# EUROPÄISCHE PATENTSCHRIFT

(11) **EP 1 056 319 B1**
(45) Veröffentlichungstag und Bekanntmachung des Hinweises auf die Patenterteilung: **27.07.2011**
(21) Anmeldenummer: 00109876.3
(22) Anmeldetag: 10.05.2000
(51) Int. Cl.: H05K 3/36

(54) **Tochterplatine zum Einsetzen in eine Mutterplatine**
Daughter board for insertion into a mother board
Carte fille pour insérer dans une carte mère

(30) Priorität: 27.05.1999 DE 19924198
(43) Veröffentlichungstag der Anmeldung: 29.11.2000
(73) Patentinhaber: SEW-EURODRIVE GmbH & Co. KG, 76646 Bruchsal (DE)
(72) Erfinder: Rusnak, Reinhold, 75053 Gondelsheim (DE)

(56) Entgegenhaltungen:
- EP-A- 0 303 975
- DE-A- 4 141 321
- DE-A- 19 802 580
- DE-B- 1 001 736
- DE-U- 9 013 966
- DE-U- 29 617 021
- US-A- 2 707 272
- PATENT ABSTRACTS OF JAPAN vol. 009, no. 061 (E-303), 19. März 1985 (1985-03-19) & JP 59 198742 A (MATSUSHITA DENKI SANGYO KK), 10. November 1984 (1984-11-10)
- PATENT ABSTRACTS OF JAPAN vol. 017, no. 121 (E-1331), 12. März 1993 (1993-03-12) & JP 04 299594 A (FUJITSU DENSO LTD), 22. Oktober 1992 (1992-10-22)

## Beschreibung

Die Erfindung betrifft ein Platinensystem, aufweisend Mutterplatine und Tochterplatine zum Einsetzen in die Mutterplatine.

Bei der elektronischen Fertigung werden elektronische Bauelemente, wie Widerstände, Kondensatoren oder auch integrierte Schaltungen, mit ihren Füßchen durch Bohrungen einer Platine eingesetzt und dann verlötet. Dabei stellt das Lot eine elektrische Verbindung zwischen den Metallflächen, beispielsweise verzinnten Layer-Schichten aus Kupfer, der Platine und den Füßchen der Bauelemente her.

Elektronische Schaltungen werden oft auch modular aufgebaut, indem kleine Platinen, im Folgenden 'Tochterplatinen' genannt, auf eine Platine, im Folgenden 'Mutterplatine' genannt, aufgesetzt bzw. in diese eingesetzt oder eingesteckt werden. Dabei wird ein Steckverbinder am Rand der Tochterplatine angebracht. Dessen Stecker-Füßchen werden dann, wie oben bei Bauelementen beschrieben, in die Mutterplatine eingesetzt und verlötet. Dabei ist jedoch der Steckverbinder aufwendig und kostspielig. Statt 'Mutterplatine' ist auch die Bezeichnung 'Hauptprint-Platine', statt 'Tochterplatine' ist auch die Bezeichnung 'Subprint-Platine' verwendbar.

Eine andere, insbesondere bei PC-Fertigung bekannte Art ist das Montieren eines Steckverbinders auf der Mutterplatine. Der Steckverbinder weist Füßchen auf, mit denen er in die Mutterplatine eingesteckt und angelötet wird. Rückseitig weist der Steckverbinder einen buchsenartigen Öffnungsschlitz auf. Die Tochterplatine wird in diesen Steckverbinder eingesteckt und weist hierfür derartige Lötpads auf, dass bei Einstecken der Tochterplatine elektrische Verbindungen zum Steckverbinderteil der Mutterplatine entstehen. Im buchsenartigen Öffnungsschlitz wird die Tochterplatine von metallischen Bügeln festgeklammert, die auch die elektrischen Kontakte darstellen. Auch diese Lösung ist kostspielig und aufwendig, insbesondere infolge des teueren komplexen Steckverbinders auf der Mutterplatine.

**Aus der** DE 296 17 021 U1**, insbesondere Seite 4 letzter Absatz, ist eine Tochterlelterplatte 1 bekannt, bei der Kontaktstifte einen rechteckigen Querschnitt aufweisen, die eine kleinere Ausdehnung In Richtung der Normalenrichtung der Tochterplatine 1 aufweisen.**

**Aus der** EP 0 303 975 A2 **ist ebenfalls eine Tochterplatine bekannt, die In eine andere leiterplatte eingesetzt wird.**

**Aus der** US 2 707 272 **ist eine tochterplatine bekannt, deren Zungen in kreisrunde Löcher der Mutterplatine eingesetzt werden.**

**Aus der** DE 90 13 966 U **ist ebenfalls eine Platine bekannt, deren Zungen in Ausnehmungen einer anderen Platine eingesetzt sind.**

**Aus der** JP 04299594 A **ist ein Platinensystem nach dem Oberbegriff des Anspruchs 1 bekannt.**

Der Erfindung liegt die Aufgabe zugrunde, ein **Platinensystem, aufweisend Mutterplatine und Tochterplatine zum Einsetzen in die Mutterplatine,**
weiterzubilden unter Vermeidung der vorgenannten Nachteile. Insbesondere soll eine einfache und kostengünstige Fertigung und Montage ermöglicht werden.

Erfindungsgemäß wird die Aufgabe b**ei einem Platinensystem, aufweisend Mutterplatine und Tochterplatine zum Einsetzen in die Mutterplatine**, gelöst nach den in Anspruch 1 angegebenen Merkmalen. Ein wesentliches Merkmal der Erfindung ist, dass die Tochterplatine Zungen aufweist, die in Bohrlöcher der Mutterplatine einsetzbar sind. Von Vorteil ist dabei, dass kein kostspieliger Stecker verwendet werden muss, sondern die Tochterplatine selbst entsprechende Ausbuchtungen oder Zungen aufweist, **wobei auf der Mutterplatine um die Bohrlöcher herum Metallflächen angeordnet sind, die in Richtung der Normalen der Tochterplatine und in entgegengesetzter Richtung eine größere Ausdehnung aufweisen als senkrecht hierzu.**

Bei einer vorteilhaften Ausgestaltung sind die Zungen derart gestaltet, dass sie aus der Platine in einem Bearbeitungsgang ausbildbar sind. Von Vorteil ist dabei, dass sie mit einer Maschine oder einem Bearbeitungsgang herstellbar sind. Dies reduziert die Kosten. Unter einem Bearbeitungsgang wird dabei im wesentlichen verstanden, dass das Werkstück, in diesem Fall eine Tochterplatine, in eine Aufnahmevorrichtung einer Maschine gebracht wird, gegebenenfalls befestigt wird, und dann von der Maschine bearbeitet wird. Die Maschine kann dabei das Werkstück bewegen und ihr Werkzeug am Werkstück mehrfach zum Einsatz bringen. Die Art der Bearbeitung kann Stanzen, Stoßen, Fräsen, Schleifen, Läppen, Hohnen oder dergleichen sein.

Bei einer weiteren vorteilhaften Ausgestaltung ist der Bearbeitungsgang ein Fräsen oder ein Stanzen. Von Vorteil ist dabei, dass genügend genaue Zungen schnell und kostengünstig fertigbar sind.

Weiterhin sind die Bohrlöcher in der Mutterplatine mindestens teilweise Rundbohrungen. Von Vorteil ist dabei, dass Rundbohrungen schnell und kostengünstig fertigbar sind.

Weiterhin sind auf der Mutterplatine um die Bohrlöcher herum Metallflächen angeordnet, die in Richtung der Normalen der Tochterplatine und in entgegengesetzter Richtung eine größere Ausdehnung aufweisen als senkrecht hierzu. Zur eindeutigen Definition dieser Richtung wird die Tochterplatine als quasi-zweidimensionales Objekt betrachtet, d.h. ihre Dicke vernachlässigt. Von Vorteil ist bei einer derartigen Gestaltung der Metallflächen, dass eine größere Stabilität der Lötverbindung geschaffen wird.

Weiterhin sind die Metallflächen rechteckförmig. Von Vorteil ist dabei, dass der eingeschränkte Platz zwischen den Zungen optimal ausnutzbar ist. Insbesondere ist dabei zu berücksichtigen, dass zwischen Metallflächen auf der Mutterplatine Mindestabstände aus verschiedenen Gründen, wie Spannungsabstand, Lotbenetzung oder dergleichen, einzuhalten sind.

Weiterhin sind die Zungen mindestens teilweise mit Metallflächen bedeckt. Von Vorteil ist dabei, dass eine elektrische Verbindung herstellbar ist, die nicht nur eine elektrische, sondern darüber hinaus auch eine mechanische Verbindung darstellt oder mechanisch stabilisiert.

Weiterhin sind die Metallflächen um die Bohrungen herum beidseitig, also auf der Einsetzseite und auf der anderen Seite, an der Mutterplatine angebracht. Bei einer weiteren vorteilhaften Ausgestaltung sind die Bohrlöcher durchkontaktiert, wobei die Bohrlochwände mindestens teilweise mit einer Metallschicht bedeckt ist. Von Vorteil ist dabei jeweils, dass die mechanische Stabilität nach dem Verlöten erhöht ist.

Weiterhin sind die Metallflächen derart gestaltet und dimensioniert sind, dass nach dem Aufbringen des Lotes beim Verlöten sich ein Lötkegel ausbildet, der im wesentlichen eine Wölbung aufweist und dessen Oberfläche im Wesentlichen glatt in die Oberfläche der Metallflächen übergeht. Von Vorteil ist dabei, dass der Lötkegel konkav ist und sich an die Metallflächen gut anschmiegt. Bei einer zu kleinen Dimensionierung der Metallfläche würde er hingegen eine perlenfömige Ausformung aufweisen. Dies wäre schlecht für die mechanische Stabilität und die elektrische Verbindung könnte nicht sicher gewährleistet werden.

Weiterhin sind elektrische Verbindungen zwischen Tochterplatine und Mutterplatine mittels Lötverbindungen herstellbar sind. Von Vorteil ist dabei, dass eine kostengünstige Verbindungsart verwendbar ist.

Weiterhin berührt Lot die beidseitigen Metallflächen der Mutterplatine, die Metallflächen der durchkontaktierten Bohrlöcher mindestens teilweise und die Metallflächen auf den Zungen und hat elektrischen Kontakt. Von Vorteil ist dabei, dass die elektrische Verbindung sicher ausbildbar ist und Fehler äußerst selten sind. Daher ist dann auch die Fertigungsqualität erhöht.

Weiterhin weisen die Metallflächen der Zungen der Tochterplatinen durchkontaktierte Bohrungen auf. Von Vorteil ist dabei, dass das Lot durch diese Durchkontaktierungen hindurchzudringen vermag und somit eine Benetzung der Metallflächen in der oben beschriebenen Art und Weise erfolgt, also das Lot sich an die Oberfläche der Metallflächen anschmiegt bzw. seine Oberfläche glatt in die Oberfläche übergeht.

### Bezugszeichenliste

- 1: Mutterplatine
- 2: Tochterplatine
- 3: Metallfläche
- 4: Zunge
- 5: Rundbohrung
- 6: Metallfläche
- 21: Lot
- 31: durchkontaktierte Bohrung
- n: Normalenrichtung

Die Erfindung wird nun anhand von einer Abbildung näher erläutert:

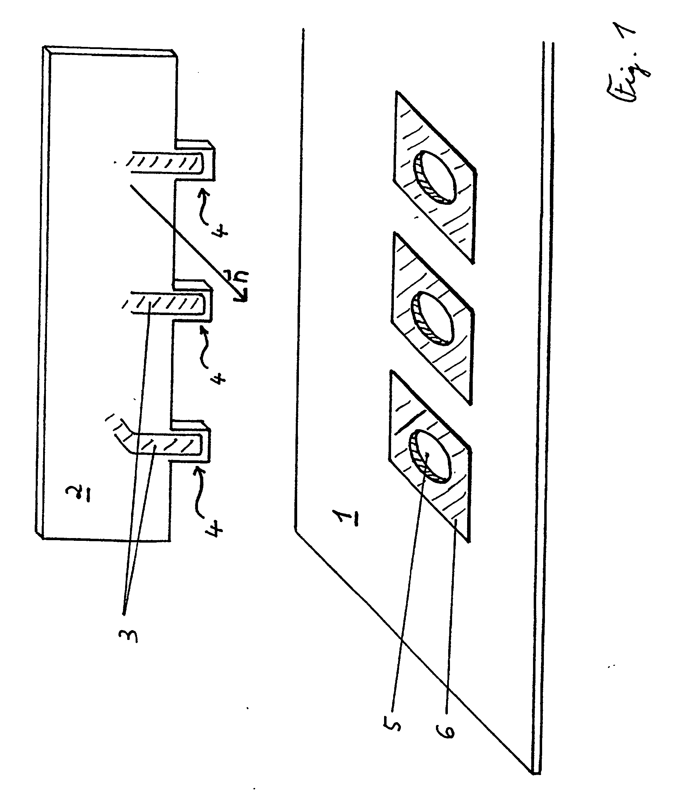

In der Figur 1 ist ein erfindungsgemäßes Ausführungsbeispiel skizziert. Die Mutterplatine 1 weist Rundbohrungen 5 auf, die umgeben sind von Metallflächen 6, die auch Kontaktflächen oder Layer genannt werden. Die Metallflächen sind oben und, parallel dazu, unten an der Mutterplatine angebracht. Sie bestehen aus Kupferflächen, die verzinnt sind.

Die rechteckförmige Ausprägung der Metallflächen 6 nutzt den Abstand zwischen den Zungen 4 der Tochterplatine 2 sehr gut aus. Die Zungen 4 weisen Metallflächen 3 auf. Die Zungen 4 werden durch einen Fräsarbeitsgang gefertigt und sind daher äußerst kostengünstig herstellbar.

Das restliche Layout der Mutter- und Tochterplatine ist in den Figuren nicht gezeigt, da es je nach Anwendung variiert. Insbesondere können auch mehrschichtige Platinen als Mutter- und/oder Tochterplatine verwendet werden.

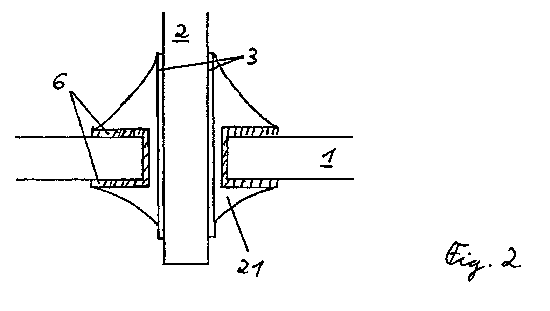

In der Figur 2 ist ein Querschnitt einer eingesetzten und angelöteten Tochterplatine 2 gezeigt. Die Metallflächen 6 sind oben und unten an der Mutterplatine angebracht und sie bedecken die Oberfläche der Bohrung 5, die also durchkontaktiert ist. Die Zungen der Tochterplatine tragen die Metallflächen 3. Nach dem Löten mittels Lötbad benetzt Lot 21 die Metallflächen 3 und 6 und füllt die Zwischenräume aus. Das Lot 21 benetzt in Meniskusform, welche oberhalb der Mutterplatine 1 steiler ausbildbar ist als unterhalb.

Die Tochterplatine 2 ist somit elektrisch sicher und mechanisch stabil verbunden mit der Mutterplatine 1.

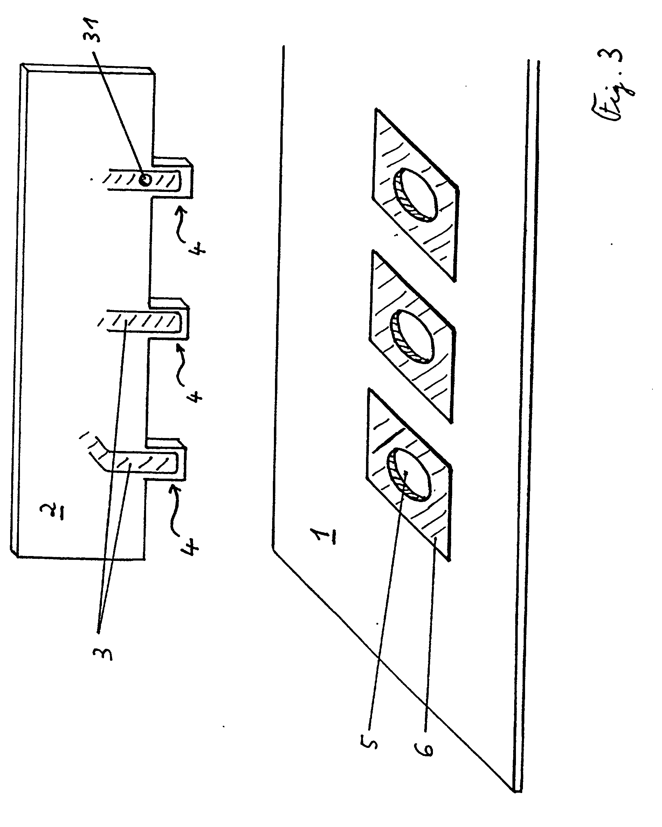

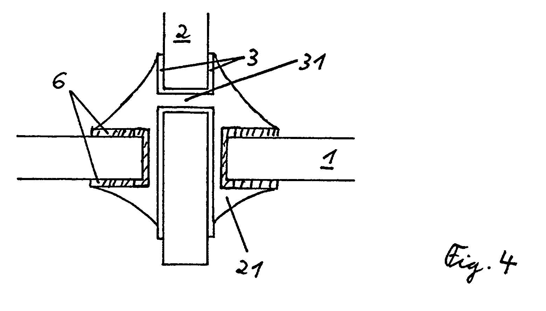

In der Figur 3 und in der Figur 4 ist ein weiteres erfindungsgemäßes Ausführungsbeispiel gezeigt, das eine weitere durchkontaktierte Bohrung 31 aufweist. Diese durchkontaktierte Bohrung 31 ist im Bereich mindestens einer Zunge der Tochterplatine angeordnet. Sie ist derart gestaltet und positioniert, dass das Lot hindurchdringen kann und alle Metallflächen im Wesentlichen benetzen kann. Außerdem ist die Position derart festgelegt, dass sie im oberen Bereich, also im Bereich des Übergangs vom Lotkegel zur Oberfläche der Metallflächen, sich befindet. Bei Verwendung einer größeren Lotmasse für die jeweilige Zunge wird ein Anschmiegen des Lots oder der Lotmasse oder des durch sie gebildeten konkaven Lotkegels unterstützt.

## Patentansprüche

1. **Platinensystem, aufweisend Mutterplatine (1) und Tochterplatine (2) zum Einsetzen in die Mutterplatine (1),**
wobei mindestens eine Lötverbindung zwischen Tochterplatine (2) und Mutterplatine (1) besteht,
**wobei**
die Tochterplatine (2) mindestens zwei Zungen (4) aufweist, die in Bohrlöcher (5) der Mutterplatine (1) einsetzbar sind
wobei die Metallflächen (6) um die Bohrungen herum beidseitig, also auf der Einsetzseite und auf der anderen Seite, an der Mutterplatine angebracht sind,
und/oder wobei die Bohrlöcher durchkontaktiert sind, wobei die Bohrlochwände mindestens teilweise mit einer Metallschicht bedeckt ist, wobei elektrische Verbindungen zwischen Tochterplatine und Mutterplatine mittels Lötverbindungen herstellbar sind, und/oder wobei Lot (21) die beidseitigen Metallflächen der Mutterplatine, die Metallflächen der durchkontaktierten Bohrlöcher mindestens teilweise und die Metallflächen auf den Zungen berührt und elektrischen Kontakt hat,
**dadurch gekennzeichnet, daß**
die Zungen der Tochterplatinen mindestens teilweise Metallflächen (3) aufweisen,
die zumindest eine durchkontaktierte Bohrung (31) aufweisen, wobei die Bohrlochwände mit einer Metallschicht bedeckt sind,
wobei die Metallflächen derart gestaltet und dimensioniert sind, dass nach dem Aufbringen des Lotes (21) beim Verlöten sich ein Lötkegel ausbildet, der im wesentlichen eine Wölbung aufweist und dessen Oberfläche im Wesentlichen glatt in die Oberfläche der Metallflächen übergeht,
wobei die Metallflächen (6) rechteckförmig sind, wobei auf der Mutterplatine (1) um jedes Bohrloch eine jeweilige, das Bohrloch umschließende Metallfläche (6) angeordnet ist, die in Richtung der Normalen der eingesetzten Tochterplatine (2) und in entgegengesetzten Richtung der Normalen der eingesetzten Tochterplatine (2) eine größere Ausdehnung aufweist als senkrecht hierzu, wobei die Bohrlöcher mindesten teilweise Rundbohrsungen (5) sind.

2. Platinensystem nach Anspruch 1,
**dadurch gekennzeichnet, dass**
die Zungen derart gestaltet sind, dass sie aus der Platine in einem Bearbeitungsgang ausbildbar und/oder fertigbar sind.

3. Platinensystem nach mindestens einem der vorangegangenen Ansprüche,
**dadurch gekennzeichnet, dass**
der Bearbeitungsgang ein Fräsen, ein Stoßen und/oder ein Stanzen ist.

## Claims

1. Printed circuit board system, having a mother board (1) and a daughter board (2) for insertion into the mother board (1),
wherein at least one soldered connection exists between the daughter board (2) and the mother board (1),
wherein the daughter board (2) has at least two tongues (4) which are insertable into drill holes (5) of the mother board (1),
wherein the metal surfaces (6) are provided on the mother board around the drill holes on both sides, i.e. on the insertion side and on the other side,
and/or wherein the drill holes are plated through, the drill-hole walls being at least partially covered with a metal coating,
wherein electrical connections between the daughter board and the mother board are producible by means of soldered connections,
and/or
wherein solder (21) touches and electrically contacts the metal surfaces on both sides of the mother board, the metal surfaces of the plated-through drill holes at least partially and the metal surfaces on the tongues,
**characterised in that**
the tongues of the daughter boards have, at least partially, metal surfaces (3) which have at least one plated-through drill hole (31), the drill-hole walls being covered with a metal coating,
wherein the metal surfaces are configured and dimensioned such that after application of the solder (21), a solder fillet forms during soldering which is substantially curved and the surface of which merges substantially smoothly into the surface of the metal surfaces,
wherein the metal surfaces (6) are rectangular,
wherein there is arranged on the mother board (1) around each drill hole a respective metal surface (6) surrounding the drill hole,
which metal surface has a greater extent, in the direction of the normal to the inserted daughter board (2) and in the opposite direction to the normal to the inserted daughter board (2), than perpendicular thereto,
wherein the drill holes are, at least partially, round drill holes (5).

2. Printed circuit board system according to Claim 1,
**characterised in that**
the tongues are configured such that they can be formed and/or fabricated from the printed circuit board in a processing operation.

3. Printed circuit board system according to at least one of the preceding claims,
**characterised in that**
the processing operation is milling, shaping and/or punching.

## Revendications

1. Système de cartes électroniques présentant une carte mère (1) et une carte fille (2) à insérer dans la carte mère (1),
au moins une liaison par brasure existant entre carte fille (2) et carte mère (1),
**dans lequel**
la carte fille (2) présente au moins deux languettes (4) qui peuvent être insérées dans des perçages (5) de la carte mère (1),
les surfaces métalliques (6) sont appliquées autour des perçages des deux côtés, c'est-à-dire du côté insertion et de l'autre côté sur la carte mère,
et/ou les perçages sont métallisés, les parois des perçages étant revêtues au moins partiellement d'une couche métallique,
des liaisons électriques pouvant être établies entre carte fille et carte mère au moyen de liaisons par brasure
et/ou le métal d'apport (21) étant en contact mécanique et électrique avec les surfaces métalliques des deux côtés de la carte mère, les surfaces métalliques des perçages métallisés au moins partiellement et les surfaces métalliques sur les languettes,
**caractérisé en ce que**
les languettes des cartes filles présentent au moins partiellement des surfaces métalliques (3) qui présentent au moins un perçage métallisé (31), les parois de perçage étant revêtues d'une couche métallique,
les surfaces métalliques étant configurées et dimensionnées de manière qu'après l'application du métal d'apport (21), il se forme lors de la brasure un cône de brasure qui présente essentiellement une courbure et dont la surface passe de manière essentiellement plane à la surface des surfaces métalliques,
les surfaces métalliques (6) étant rectangulaires,
une surface métallique (6) entourant le perçage étant disposée autour de chaque perçage sur la carte mère (1),
laquelle présente une plus grande extension en direction de la normale à la carte fille (2) insérée et en direction opposée à la normale à la carte fille (2) insérée que perpendiculairement à celles-ci,
les perçages étant au moins partiellement des perçages ronds (5).

2. Système de cartes électroniques selon la revendication 1,
**caractérisé en ce que**
les languettes sont configurées de manière à pouvoir être formées et/ou fabriquées à partir de la carte en une opération d'usinage.

3. Système de cartes électroniques selon au moins une des revendications précédentes,
**caractérisé en ce que**
l'opération d'usinage est un fraisage, une percussion et/ou un découpage.
